# EUROPEAN PATENT APPLICATION

(11) **EP 4 776 764 A1**
(43) Date of publication of application: **15.07.2026**
(21) Application number: 25222096.7
(22) Date of filing: 10.12.2025
(51) Int. Cl.: H05K 7/14

(54) **MODULAR HIGH POWER DENSITY RACK BUSBAR AND CONNECTOR INTERFACE FOR HIGH POWER RACKS**

(30) Priority: 11.12.2024 US 202418977405
(71) Applicant: Google LLC, Mountain View, CA 94043 (US)
(72) Inventor: Liu, Tanya, Mountain View, California, 94043 (US); Liu, Melody, Mountain View, California, 94043 (US)
(74) Representative: Betten & Resch

(57) **Abstract**

The present disclosure is generally directed to a modular busbar assembly that can be adjusted to fit varying rack power targets and connector interfaces, accommodating multiple connector geometries along one cost-effective assembly. The modular busbar assembly enables high power densities at powershelf regions by accommodating single- and double-pole connectors and connector contacts at various positions relative to the modular busbar assembly. The modular busbar assembly is customizable because the auxiliary busbar geometry may be altered independently from the primary busbar geometry.

## Description

### BACKGROUND

Data center (DC) rack power density is projected to increase by more than three times, which, at conventional rack nominal voltages, can lead to an increase by more than three times in current delivery per rack powershelf. The maximum current carrying capacity is limited by the available side area between the connector electrical contacts and the vertical busbar, as the interfacial resistance across the contact-busbar interface is a large source of Joule heating. If the output current exceeds the current carrying capacity, or ampacity, of the connector, the plastic connector housing or the vertical busbar insulator can melt and cause a short circuit or electrical fire. With existing connector limitations, a three times increase in rack power would also require a three times increase in rack space for power delivery, which cannot meet the payload requirement.

To increase connector ampacity, conventional methods include increasing the contact side area between the connector and vertical busbar by increasing the connector height. However, a three times higher power rack would require a three times taller connector which would not meet the power density requirement.

Another conventional method to increase connector ampacity is to actively cool the connector with airflow. However, the airflow required for a three times rack power increase is not feasible because the connector does not have enough exposed side area for the required airflow.

Another conventional method to increase connector ampacity is to liquid cool the busbar so that the busbar can act as a cold sink for the connector. However, liquid cooling the busbar may impose further restrictions on available rack space for payloads, may limit deployability, and may still not be sufficient to maintain the same connector temperature as current connectors.

Another conventional method to increase connector ampacity is to swap connector and busbar insulators to a plastic with higher relative thermal index (RTI). Current busbar insulators have a maximum temperature of approximately 130°C due to the RTI of the insulator material. Other insulator materials with higher RTI could be considered, but could be deficient in sourcing availability, electrical insulating properties, and structural integrity necessary for robust, blind-mate connectors and busbars.

### BRIEF SUMMARY

The present disclosure is generally directed to a modular busbar assembly that enables high power densities at powershelf regions. The modular busbar assembly can be adjusted to fit varying rack power targets and connector interfaces, accommodating multiple connector geometries along one cost-effective assembly. For example, the modular busbar assembly can accommodate single- and double-pole connectors and connector contacts at various positions relative to the modular busbar assembly, while remaining compatible with existing off-the-shelf hardware.

In one aspect of the disclosure, a modular busbar assembly may include a primary positive busbar to carry a positive current from a source connector. The primary positive busbar may include a positive body. The modular busbar assembly may also include a primary return busbar to carry a negative current to a return contact. The primary return may include a return body. The modular busbar assembly may also include an auxiliary busbar coupled to a coupling side of at least one of the positive body or the return body. The auxiliary busbar may be spaced apart from at least one of the primary positive busbar or the primary return busbar to which the auxiliary busbar is coupled. The modular busbar assembly may also include a recess defined by a space between the auxiliary busbar and at least one of the primary positive busbar or the primary return busbar to which the auxiliary busbar is coupled.

In some examples, the recess may be U-shaped and may receive a connector. The connector may connect at least one of the source connector or the return contact to the modular busbar assembly.

In some examples, at least one of the primary positive busbar or the primary return busbar may include a protrusion side transverse to the coupling side. The protrusion may be coupled to the protrusion side. The auxiliary busbar and the protrusion of at least one of the primary positive busbar or the primary return busbar may define the recess.

In some examples, the auxiliary busbar and at least one of the primary positive busbar or the primary return busbar may each have an opening, which may receive a coupling. The coupling may join the auxiliary busbar to at least one of the primary positive busbar or the primary return busbar to which the auxiliary busbar is coupled.

In some examples, the auxiliary busbar may be brazed to at least one of the primary positive busbar or the primary return busbar.

In some examples, at least one of the primary positive busbar or the primary return busbar may receive at least one single-pole connector or at least one double-pole connector.

In some examples, the auxiliary busbar may extend in at least one direction parallel to at least one of the coupling side or a noncoupling side of at least one of the positive body or the return body to which the auxiliary busbar is coupled.

In some examples, the auxiliary busbar may be a positive auxiliary busbar coupled to the primary positive busbar. The modular busbar assembly may further include an auxiliary return busbar coupled to the primary return busbar.

In some examples, the recess may be a first recess. The positive body may include a first protrusion side transverse to the coupling side on the primary positive busbar. A first protrusion may be coupled to the first protrusion side. The first recess may be defined by the first protrusion and the auxiliary positive busbar. The return body may include a second protrusion side transverse to the coupling side on the primary return busbar. A second protrusion may be coupled to the second protrusion side. The modular busbar assembly may have a second recess, which may be defined by the second protrusion and the auxiliary return busbar.

In some examples, the coupling side of the primary positive busbar may oppose the coupling side of the primary return busbar.

In some examples, the coupling side of the primary positive busbar may be transverse to the coupling side of the primary return busbar.

In some examples, the auxiliary busbar may include a recess, which may receive a connector.

In some examples, the connector may be a first connector. The recess may be a first recess, defined by two protrusions coupled to the auxiliary busbar. An external side of one of the two protrusions and the coupling side of at least one of the positive body or the return body may define a second recess, which may receive a second connector.

In some examples, the auxiliary busbar may include copper.

In another aspect of the disclosure, a modular busbar assembly may include a primary positive busbar, which may carry a positive current from a source connector. The primary positive busbar may include a positive body. The modular busbar assembly may also include a primary return busbar, which may carry a negative current to a return contact. The primary return may include a return body. The modular busbar assembly may also include an auxiliary busbar coupled to a side of at least one of the positive body or the return body of at least one of the primary positive busbar or the primary return busbar. The auxiliary busbar may be positioned transverse to a shortest length of at least one of the primary positive busbar or the primary return busbar to which the auxiliary busbar is coupled. The shortest length may be coupled to a longest length of the at least one of the primary positive busbar or the primary return busbar to which the auxiliary busbar is coupled

In some examples, the auxiliary busbar may be a positive auxiliary busbar coupled to the primary positive busbar. The modular busbar assembly may include an auxiliary return busbar coupled to the primary return busbar.

In some examples, the coupling side of the primary positive busbar and the coupling side of the primary return busbar may extend along an axis.

In some examples, the auxiliary positive busbar and the auxiliary return busbar may be positioned along an axis so that the auxiliary positive busbar may interface with a series of positive contacts along the axis and so that the auxiliary return busbar may interface with a series of return contacts along the axis.

In some examples, the auxiliary positive busbar and a portion of the auxiliary return busbar may be parallel so that the auxiliary positive busbar may interface with a series of positive connector contacts parallel to a series of return contacts. The auxiliary return busbar may interface with the series of return contacts.

In another aspect of the disclosure, a modular busbar assembly may include a primary positive busbar, which may carry a positive current from a source connector. The primary positive busbar may include a positive body having an opening, which may receive a coupling. The positive body may include a coupling side and a protrusion side transverse to the coupling side. A protrusion may be coupled to the protrusion side. The modular busbar assembly may also include a primary return busbar, which may carry a negative current to a return contact. The primary return may include a return body having an opening, which may receive a coupling. The return body may include a coupling side and a protrusion side transverse to the coupling side. A protrusion may be coupled to the protrusion side. The modular busbar assembly may also include an auxiliary busbar coupled to a side of at least one of the positive body or the return body of at least one of the primary positive busbar or the primary return busbar via a coupling in the opening of the at least one of the positive body or the return body to which the auxiliary busbar is coupled. The auxiliary busbar may be spaced apart from at least one of the primary positive busbar or the primary return busbar to which the auxiliary busbar is coupled.

### BRIEF DESCRIPTION OF THE DRAWINGS

FIG. 1 is a side view of a rack assembly and top perspective enlarged view of a modular busbar assembly, according to aspects of the disclosure.
FIG. 2A is a top view of a modular busbar assembly of FIG. 1.
FIG. 2B is an exploded top view of the modular busbar assembly of FIG. 1.
FIG. 3 is a top view of a modular busbar assembly with single -pole connectors, according to aspects of the disclosure.
FIG. 4 is a top view of a busbar assembly with double-pole connectors, according to aspects of the disclosure.
FIG. 5 is a front view of a modular busbar assembly with additional copper pieces in the powershelf area, according to aspects of the disclosure.
FIG. 6A is a rear view of a modular busbar assembly interfacing with positive and return contact contacts, according to aspects of the disclosure.
FIG. 6B is an exploded rear view of a portion of the modular busbar assembly of FIG. 6A.
FIG. 6C is an exploded rear view of another portion of the modular busbar assembly of FIG. 6A.
FIG. 7A is a rear view of another modular busbar assembly interfacing with positive and return contact contacts, according to aspects of the disclosure.
FIG. 7B is an exploded rear view of a portion of the modular busbar assembly of FIG. 7A.
FIG. 8A is a top view of a modular busbar assembly with single- and double-pole connectors, according to aspects of the disclosure.
FIG. 8B is an exploded top view of a portion of the modular busbar assembly of FIG. 8A.
FIG. 8C is an exploded top view of another portion of the modular busbar assembly of FIG. 8A.
FIG. 9A is a top view of another modular busbar assembly with single- and double-pole connectors, according to aspects of the disclosure.
FIG. 9B is an exploded top view of a portion of the modular busbar assembly of FIG. 9A.
FIG. 10 is a top view of a modular busbar assembly with double-pole connectors within recesses in primary positive and return busbars, according to aspects of the disclosure.
FIG. 11 is a side view of a modular busbar assembly with a single-pole connector within a recess in an auxiliary positive busbar, according to aspects of the disclosure.
FIG. 12 is a side view of a modular busbar assembly with single-pole connectors within recesses in an auxiliary positive busbar, according to aspects of the disclosure.

### DETAILED DESCRIPTION

The disclosure is generally directed to a modular busbar assembly that enables high current density output from a powershelf with minimal impact on payload space and that can still be used in existing industry standard payload-to-busbar interfaces. The modular busbar assembly may enable a three times improvement in existing industry-standard power connectors. The modular busbar assembly may be used in any region of the rack where a machine connects to the vertical busbar and is thus not limited to use in the power delivery region.

The modular busbar assembly can be adjusted to fit varying rack power targets and connector interfaces, accommodating multiple connector geometries along one cost-effective assembly. The modular busbar assembly enables high power densities at powershelf regions by accommodating different connector geometries at different parts of the busbar, which, for example, may allow single- and double-pole connectors and connector contacts at various positions relative to the modular busbar assembly. The modular busbar assembly is customizable because the auxiliary busbar geometry may be altered independently from the primary busbar geometry. In some aspects, the modular busbar assembly may include an auxiliary positive busbar removably coupled to a primary positive busbar and an auxiliary return busbar removably coupled to a primary return busbar.

The modular busbar assembly may preserve payload space in a rack by reducing vertical height of power-dense powershelves by allowing for different connector geometry at the powershelf region. Additionally, the modular busbar assembly may save space in lower-powered payloads by allowing space-saving, industry-standard connector geometries in the lower-powered payload region. Instead of connector-busbar geometry that is wider throughout the vertical rack, the modular busbar assembly enables a slimmer connector-busbar geometry for use in lower-powered payloads, and additional space can be allocated in the higher-powered powershelf areas that require more connector contact area.

The modular busbar assembly can be used with existing off-the-shelf hardware. Either the auxiliary or primary busbars may include industry standard tips compatible with off-the-shelf machines. Additionally, existing connector contacts can be horizontally rearranged within a connector housing to triple the contact area of auxiliary busbars.

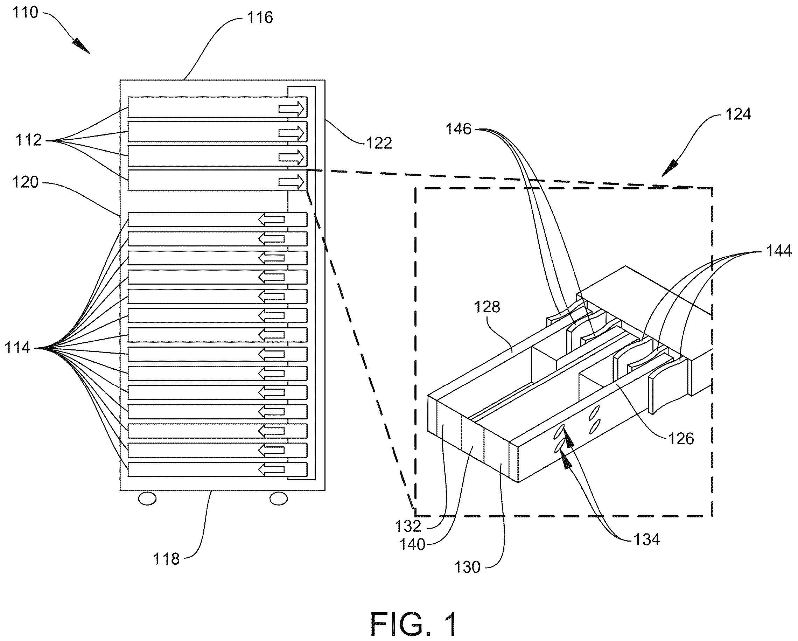

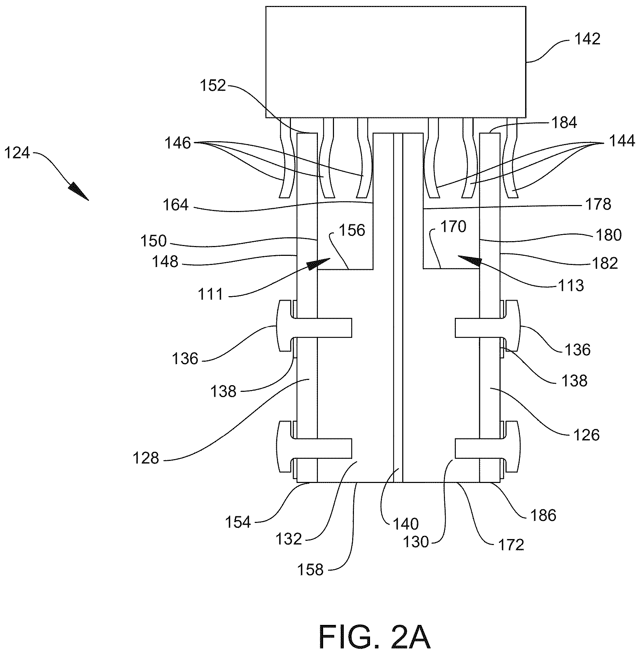

FIG. 1 illustrates an example of a data center rack including a modular busbar assembly, which is further illustrated in FIGs. 2A-2B. The rack 110 may be configured to receive a series of powershelves 112 and a series of payloads 114. With the modular busbar assembly 124, each busbar 128, 132, 130, and 126 can receive a different connector geometry at the payload 114 and at the powershelf 112.

The rack may have a first edge 116, a second edge 118 opposite and parallel to the first edge 116, and third and fourth edges 120, 122 coupled to and extending between the first and second edges 116, 118. The first, second, third, and fourth edges 116, 118, 120, 122 may form a rectangular perimeter of the rack 110. The rack 110 may include a panel (not shown) coupled to the first, second, third, and fourth edges 116, 118, 120, 122. However, in other aspects of the disclosure, the rack 110 may not include a panel. Powershelves 112 and payloads 114 may be configured to be inserted into the rack 110. For example, the powershelves 112 and payloads 114 may extend between two edges of the rack 110, e.g., first edge 116 and second edge 118, and may be positioned between third and fourth edges 120, 122. The series of powershelves 112 may be positioned in rows between the first edge 116 and the payloads 114. The payloads 114 may be positioned in rows between the powershelves 112 and the second edge 118. The powershelves 112 may transfer a current from a source connector in a direction from the third edge 120 to the fourth edge 122 to a direction towards the payloads 114. The payloads 114 may then transfer the current in a direction from the fourth edge 122 to the third edge 120 to a return contact. The return contact may be a system configured to receive the current from rack 110.

Each powershelf 112 may include one modular busbar assembly 124. The modular busbar assembly 124 may include an auxiliary return busbar 128, a primary return busbar 132, an insulator 140, a primary positive busbar 130, and an auxiliary positive busbar 126. When the powershelf 112 is placed in the rack 110, each busbar 128, 132, 130, and 126 may be positioned extending between the third and fourth edges 120, 122 of the rack 110, with the auxiliary return busbar 128 positioned closest to the panel (not shown) of the rack 110. The primary return busbar 132 may be adjacent and parallel to the auxiliary return busbar 128. The insulator 140 may be adjacent to, parallel to, and between the primary positive busbar 130 and the primary return busbar 132. The auxiliary positive busbar 126 may be adjacent to the primary return busbar 132 and may be positioned farthest from the panel (not shown) of the rack 110. In other aspects, the modular busbar assembly 124 may be inserted into rack 110 in an opposite position so that the auxiliary return busbar 128 may be positioned farthest from the panel (not shown) of the rack 110, and the auxiliary positive busbar 126 may be positioned closest to the panel (not shown) of the rack 110.

In other aspects of the disclosure, the modular busbar assembly may include multiple primary positive busbars and therefore multiple auxiliary positive busbars. Additionally, in other aspects of the disclosure, the modular busbar assembly may include multiple primary return busbars and therefore multiple auxiliary return busbars. The modular busbar assembly can also include both multiple primary positive and return busbars and thus both multiple auxiliary positive and return busbars.

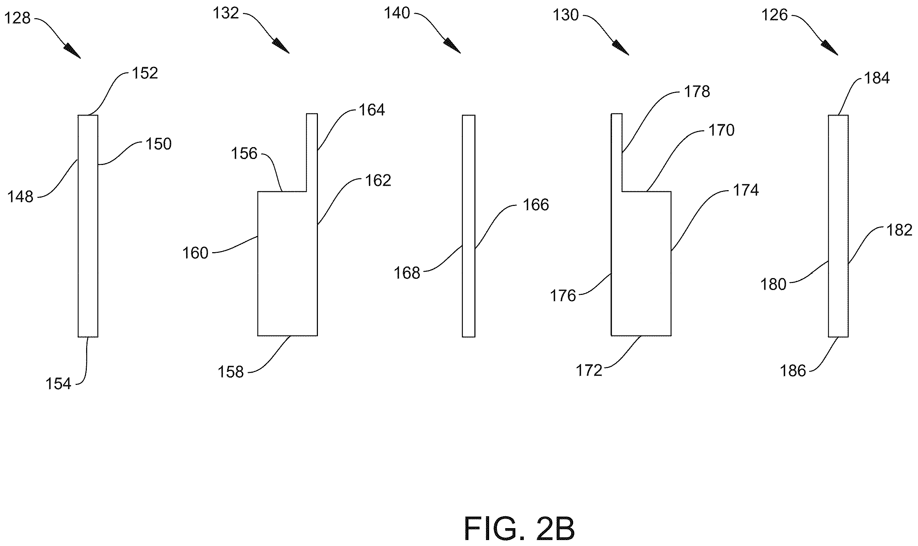

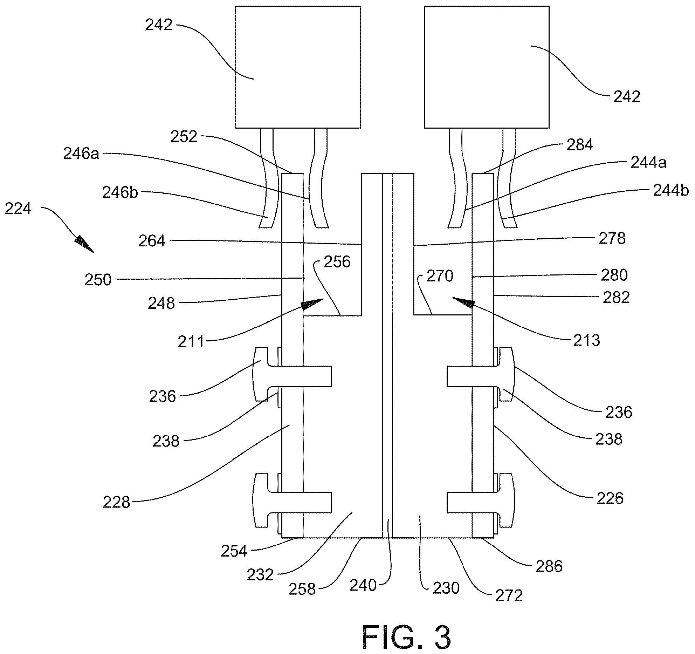

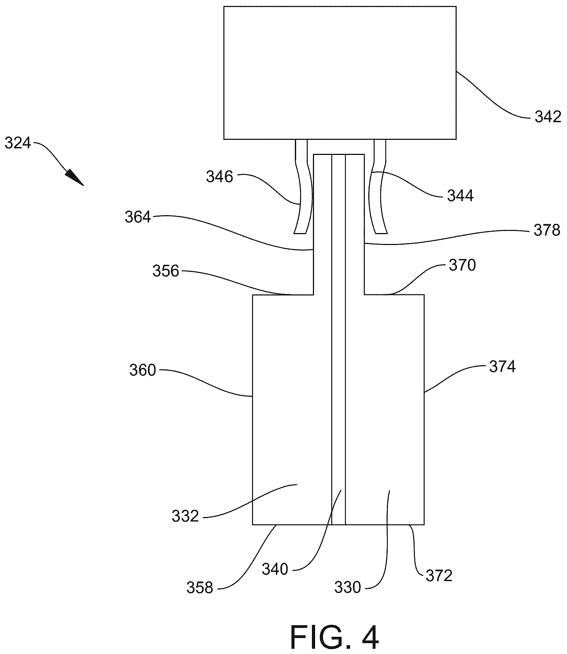

The primary positive busbar 130 and the auxiliary positive busbar 126 may receive a charge from at least one positive contact 144 as a source connector, and the primary return busbar 132 and auxiliary return busbar 128 may transfer the charge to at least one return contact 146 as a return contact. At least one positive contact 144 may transmit high current power from a source to the modular busbar assembly 124, and at least one return contact 146 may transmit the high current return from the series of payloads 114 to the modular busbar assembly 124. The positive and negative contacts 144, 146 may comprise a metallic material. The contacts may be combined to form different connector assemblies. Connector assemblies may include one or more single-pole connectors, one or more double-pole connectors, or a combination of single- and double-pole connectors. Single-pole connectors may include one or more strips of metal contacts to contact sides of a busbar with single-direction current flow, as shown in at least FIGs. 3, 10, 11, and 12. Double-pole connectors may include two or more strips of metal contacts to contact sides of busbars with bi-directional current flow, as shown in at least FIG. 4. A double-pole connector may therefore have contacts with both positive and return current flow, while a single-pole connector may support exclusively positive or return current flow. The contact strips in the single- and double-pole connectors may include a bend so that the apex of the bend contacts a busbar. The positive and return contacts 144, 146 may be coupled to a connector housing 142, as shown in FIGs. 2A and 2B. The connector housing 142 may include openings (not shown) in which the contacts 144, 146 are received so as to provide support to the contacts 144, 146 and thus prevent movement of the contacts 144, 146 when interfacing with busbars (*i.e.,* auxiliary return busbar 128, primary return busbar 132, primary positive busbar 130, and auxiliary positive busbar 126). The contacts may be combined to form both single- and double-pole connectors depending on the specific housing design.

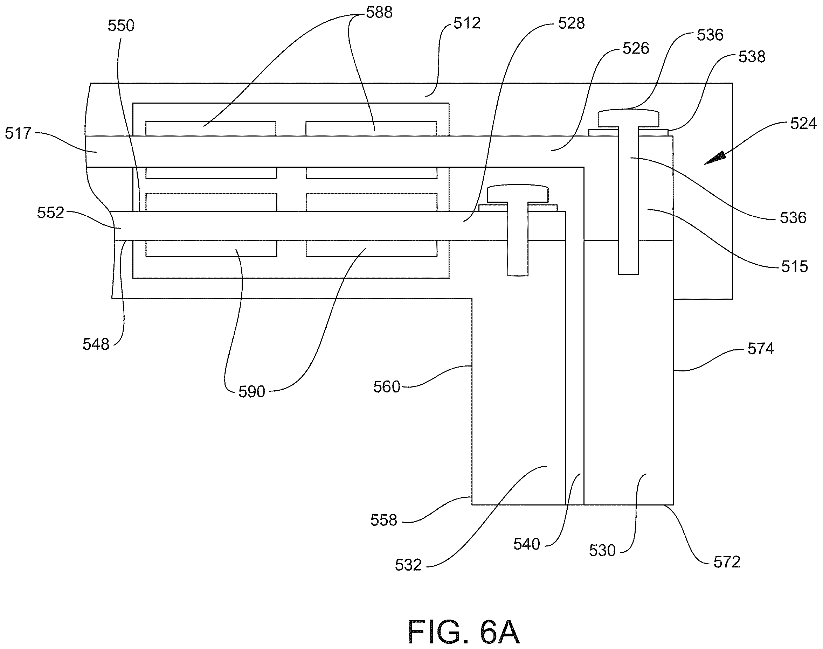

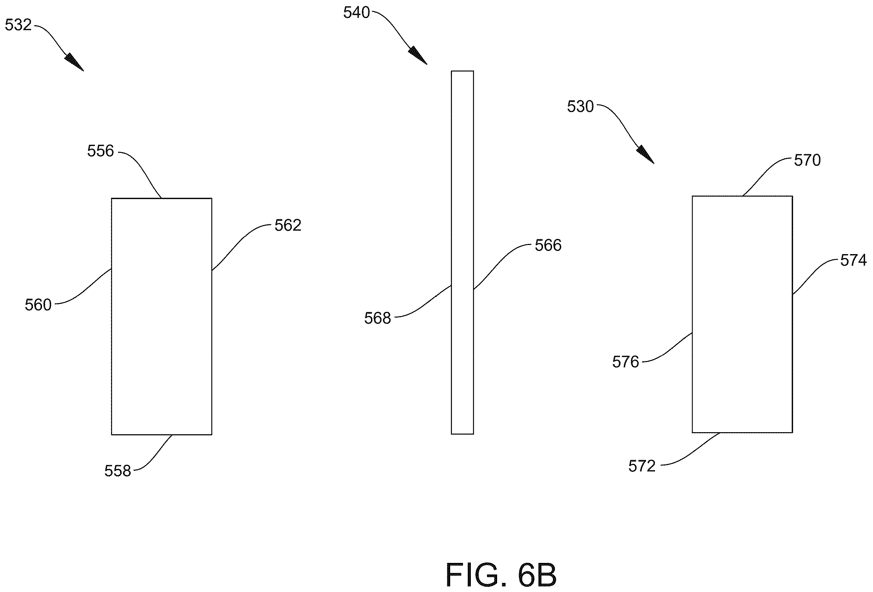

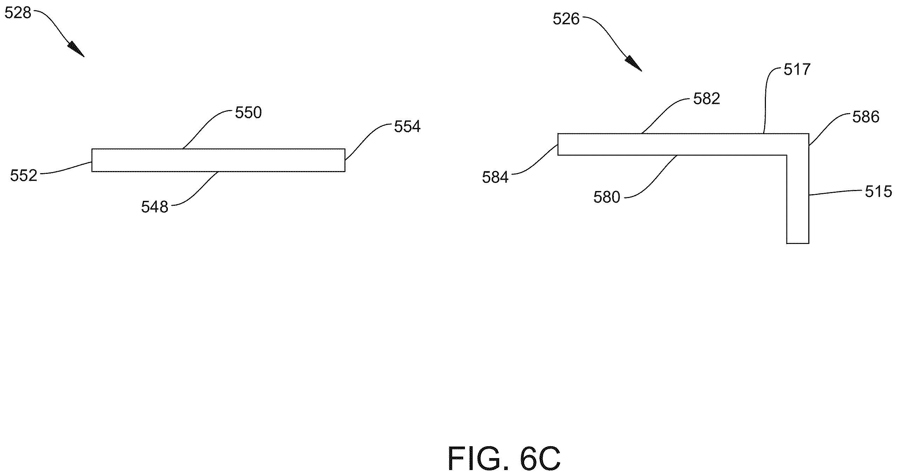

In other aspects of the disclosure, the connectors can be any form of positive and return contact. For example, the positive and return contacts may be a series of metal strips lined in an intended direction for the busbar in which it contacts, as discussed in further detail in connection with FIGs. 6A-7B.

Each of the busbars 128, 132, 130, 126 may be a metal extrusion for high current power distribution. The busbars 126, 128, 130, 132 may comprise copper, brass, aluminum, or a mixture of these or other conductive materials.

The busbars 126, 128, 130, 132 may include openings 134 for receiving couplings. The openings 134 in the auxiliary positive and return busbars 126, 128 may be a hole for receiving a coupling therethrough, and the openings 134 in the primary positive and return busbars 130, 132 may be a hole for receiving a coupling therethrough or a recess for partially receiving a coupling. One or more of the couplings may be screws 136, and the coupling may be supported by a washer 138 to distribute the load of the coupling. One or more of the openings 134 may be threaded to secure the screws 136. For example, there may be four openings 134 in the auxiliary positive busbar 126, and four corresponding openings (not shown) in the primary positive busbar 130 that align with the four openings 134 of the auxiliary positive busbar 126. Similarly, there may be four openings (not shown) in the auxiliary return busbar 128, and four corresponding openings (not shown) in the primary return busbar 132 that align with the four openings of the auxiliary return busbar 128. Though FIG. 1 includes four openings 134 in the auxiliary positive busbar 126, there may be any number of openings in the busbars 126, 128, 130, 132 as long as at least one opening is aligned between the primary positive busbar 130 and auxiliary positive busbar 126 and between the primary return busbar 132 and the auxiliary return busbar 128. A benefit of using couplings 136 to secure the primary busbars 130, 132 to the auxiliary busbars 126, 128 is that the auxiliary busbars 126, 128 are removable from the primary busbars 130, 132, as discussed in further detail in connection with FIG. 4, and that the screws 136 provide pressure between the busbar contact sides for improved contact resistance and transfer current and heat.

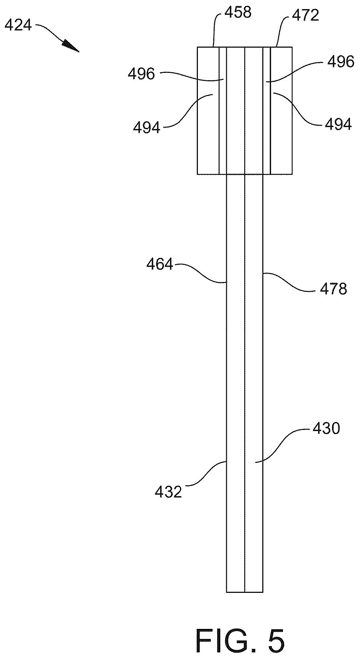

In other aspects, the connection between the primary positive busbar and auxiliary positive busbar and between the primary return busbar and the auxiliary return busbar may be through brazing, as discussed in further detail in connection to FIG. 5.

The insulator 140 may separate the positive and return currents for safety. The insulator 140 may comprise glass, porcelain, a composite polymer, or another insulating material. The porcelain may include clay, sapphire, boron nitride, quartz, alumina, feldspar, etc. The composite polymer may include silicone rubber, ethylene propylene diene monomer rubber, etc. The primary positive and return busbars 130, 132 may be supported by the insulator 140, and, in such cases, the insulator 140 may further include a magnetic material.

As best shown in FIG. 2B, the primary return busbar 132 may be rectangular with a protrusion 164 coupled to one side of the primary return busbar 132. Specifically, the primary return busbar 132 may have a coupling side 160 intended to be positioned adjacent to the auxiliary return busbar 128 and may also have three non-coupling sides 156, 158, 162. The first non-coupling side may be a protrusion side 156 perpendicular to the coupling side 160, and a first protrusion 164 may be coupled to the protrusion side 156. The second non-coupling side may be an insulator side 162 opposite the coupling side 160, and the insulator side 162 may be configured to be positioned adjacent to the insulator 140. The third non-coupling side may be a rear side 158 opposite the protrusion side 156. The rear and protrusion sides 156, 158 may be the sides with the shortest length of the busbar body, and the coupling and insulator sides 160, 162 may be the sides with the longest length. The protrusion 164 may include a length shorter than the rear and protrusion sides 156, 158.

The primary positive busbar 130 may also be rectangular with a protrusion 178 coupled to one side of the primary positive busbar 130. Specifically, the primary positive busbar 130 may have a coupling side 174 intended to be positioned adjacent to the auxiliary positive busbar 126 and may also have three non-coupling sides 170, 172, 176. The first non-coupling side may be a protrusion side 170 perpendicular to the coupling side 174, and a second protrusion 178 may be coupled to the protrusion side 170. The second non-coupling side may be an insulator side 176 opposite the coupling side 174, and the insulator side 176 may be intended to be positioned adjacent to the insulator 140. The third non-coupling side may be a rear side 172 opposite the protrusion side 170. The rear and protrusion sides 170, 172 may be the sides with the shortest length, and the coupling and insulator sides 174, 176 may be the sides with the longest length.

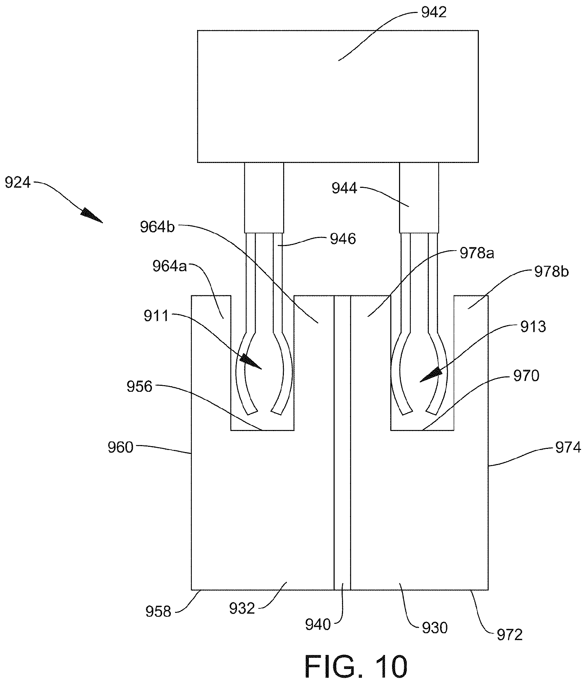

In other aspects, the primary and return busbars may be any shape that includes a protrusion for payload connectors to interface with and can be extruded as a single profile. Additionally, in other aspects the primary positive and return busbars may not include a protrusion, especially if there are manufacturing limitations and the auxiliary busbars are solely used for connector interfaces. Further, the primary positive and return busbars may include two or more protrusions, as discussed in further detail in connection to FIG. 10.

The auxiliary return busbar 128 may be rectangular. The auxiliary return busbar 128 may have a primary-facing side 150 intended to be positioned adjacent to the coupling side 160 of the primary return busbar 132, an external side 148 opposite the primary-facing side 150, and top and rear sides 152, 154 opposite each other and perpendicular to the primary-facing and external sides 148, 150.

The auxiliary positive busbar 126 may also be rectangular. The auxiliary positive busbar 126 may have a primary-facing side 180 intended to be positioned adjacent to the coupling side 174 of the primary positive busbar 130, an external side 182 opposite the primary-facing side 180, and top and rear sides 184, 186 opposite each other and perpendicular to the primary-facing and external sides 180, 182.

The insulator 140 may be rectangular. The insulator 140 may have a positive-facing side 166 intended to be positioned adjacent to the insulator side 176 of the primary positive busbar 130 and a return-facing side 168 intended to be positioned adjacent to the insulator side 162 of the primary return busbar 132. In other aspects, the insulator can include protrusions on the primary-facing side and/or the return-facing side to insulate additional sides of the primary busbars.

The first and second protrusions 164, 178 of the primary positive and return busbars 130, 132 are intended to be positioned adjacent to the insulator 140. As such, each protrusion 164, 178 defines a recess with the auxiliary positive and return busbars 126, 128. Specifically, the first protrusion 164 defines a first recess 111 with the auxiliary return busbar 128, and the second protrusion 178 defines a second recess 113 with the auxiliary positive busbar 126. The first and second recesses 111, 113 may be U-shaped.

The first and second recesses 111, 113 may enable connectors to have multiple contacts. The multiple contacts may be, for example, six or more contacts. For example, as shown in FIGs. 1 and 2A, the multiple contacts may be six total contacts, including three positive contacts and three return contacts. The multiple contacts may be a double-pole connector because the multiple contacts may be housed in one connector housing and current may flow in both directions. Specifically, three return single-pole connectors 146 may each contact the external side 148 of the auxiliary return busbar 128, the primary-facing side 150 of the auxiliary return busbar 128, and the first protrusion 164 of the primary return busbar 132. Additionally, three positive single-pole connectors 144 may each contact the external side 182 of the auxiliary positive busbar 126, the primary-facing side 180 of the auxiliary positive busbar 126, and the second protrusion 178 of the primary return busbar 132. The busbar contact points for the connectors 144, 14446 may be points on an axis perpendicular to the rear sides 154, 158, 172, 186 of the auxiliary positive busbar 126, primary positive busbar 130, auxiliary return busbar 128, and primary return busbar 132. Thus, the modular busbar assembly 124 may be used in areas requiring high current density because of the increased busbar-connector contact area.

FIG. 3 illustrates another example of a modular busbar assembly. Modular busbar assembly 224 is similar to modular busbar assembly 124 of FIGs. 1-2B, and therefore like elements are referred to with similar numerals within the 200-series of numbers. The description of equivalent features of modular busbar assembly 224 and modular busbar assembly 124 is omitted for brevity.

Modular busbar assembly 224 differs from modular busbar assembly 124 of FIGs. 1-2B in that only two positive single-pole connectors and two return single-pole connectors are used. As shown in FIG. 3, a first positive single-pole contact 244b may contact the external side 282 of the auxiliary positive busbar 226, and a second positive single-pole contact 244a may contact the primary-facing side 280 of the auxiliary positive busbar 226. Additionally, a first negative single-pole contact 246b may contact the external side 248 of the auxiliary return busbar 228, and a second return single-pole contact 246a may contact the primary-facing side 250 of the auxiliary return busbar 228. Thus, the modular busbar assembly 224 can be used only with single-pole connectors for the auxiliary busbar connectors, which enables high power use because single-pole connectors can be made of only metal and thus may not need to be separated by plastic insulators, which lowers the temperature.

In other aspects, contact 244a may be combined with contact 244b to form a single-pole connector. In other aspects, contact 246a may also be combined with contact 246b to form a single-pole connector.

FIG. 4 illustrates another example of a modular busbar assembly. Modular busbar assembly 324 is similar to modular busbar assembly 124 of FIGs. 1-2B, and therefore like elements are referred to with similar numerals within the 300-series of numbers. The description of equivalent features of modular busbar assembly 324 and modular busbar assembly 124 is omitted for brevity.

Modular busbar assembly 324 differs from modular busbar assembly 124 of FIGs. 1-2B in that auxiliary positive and return busbars are not connected to the primary positive and return busbars 330, 332. Instead, the modular busbar assembly 324 may include a primary positive busbar 330 adjacent to an insulator 340, which may be adjacent to a primary return busbar 332. The primary positive and return busbars 330, 332 and insulator 340 may be positioned and shaped the same as the primary positive and return busbars 130, 132 and insulators 140 in FIGs. 1-3. Thus, the modular busbar assembly 324 may be used without auxiliary busbars, which may be beneficial in lower-powered payload areas and may allow use as off-the-shelf hardware.

Modular busbar assembly 324 also differs from modular busbar assembly 124 of FIGs. 1-2B in that the modular busbar assembly 324 includes double-pole connectors including one positive and one return single-pole contact. A positive single-pole contact 344 may contact the second protrusion 378 of the primary return busbar 332. Additionally, a return single-pole contact 346 may contact the first protrusion 364 of the primary return busbar 332.

FIG. 5 illustrates another example of a modular busbar assembly. Modular busbar assembly 424 is similar to modular busbar assembly 324 of FIG. 4, and therefore like elements are referred to with similar numerals within the 400-series of numbers. The description of equivalent features of modular busbar assembly 424 and modular busbar assembly 324 is omitted for brevity.

Modular busbar assembly 424 differs from modular busbar assembly 324 of FIG. 4 in that the modular busbar assembly 424 includes copper pieces 494 coupled to the coupling sides of the primary positive and return busbars 430, 432. Additionally, the primary positive and return busbars 430, 432 may not include openings to receive a screw because the copper pieces 494 may be brazed onto the coupling sides (not shown) of the primary positive and return busbars 430, 432. Brazing is a metal-joining process using a flowing filler metal to connect two or more metals. The filler metal, *e.g.* filler metal 496, may include aluminum-silicon, copper, copper-silver, copper-zinc (brass), copper-tin (bronze), gold-silver, nickel alloy, silver, or amorphous brazing foil which may use nickel, iron, copper, silicon, boron, phosphorous, etc. The heating method for brazing may include torch brazing, furnace brazing, induction brazing, dip brazing, resistance brazing, infrared brazing, blanket brazing, electron beam and laser brazing, or braze welding. A benefit of brazing the primary busbars to the auxiliary busbars is to selectively increase the cross-sectional area for current flow along the length of the modular busbar assembly. A larger cross-section reduces the electrical resistance, Joule heating, and subsequent temperature rise in the portion of the busbar with additional brazed pieces. Copper pieces 494 may therefore be added to regions of the primary positive and return busbars 430, 432 with high current flow to reduce temperature rise due to the previously mentioned reasons and also add additional thermal mass for heatsinking.

FIGs. 6A-6C illustrate another example of a modular busbar assembly. Modular busbar assembly 524 is similar to modular busbar assembly of 124 of FIGs. 1-2B, and therefore like elements are referred to with similar numerals within the 500-series of numbers. The description of equivalent features of modular busbar assembly 524 and modular busbar assembly 124 is omitted for brevity.

Modular busbar assembly 524 differs from modular busbar assembly of 124 of FIGs. 1-2B in that the auxiliary positive and return busbars 526, 528 interface with connector contacts 588, 590 that may be rotated 90 degrees relative to the direction of current flow along the primary positive and return busbars 530, 532. To facilitate this type of connector, the primary positive and return busbars 530, 532 the coupling side may be on one of the two sides with the shortest length, such as coupling and rear sides 556, 558. Specifically, the primary return busbar 532 may have a coupling side 556 intended to be positioned adjacent to the auxiliary return busbar 528 and may also have three non-coupling sides. The first non-coupling side may be an external side 560 perpendicular to the coupling side 556. The second non-coupling side may be an insulator side 562 opposite the external side 560, and the insulator side 562 may be intended to be positioned adjacent to the insulator 540. The third non-coupling side may be a rear side 558 opposite the coupling side 556. The coupling and rear sides 556, 558 may be the sides with the shortest length, and the external and insulator sides 560, 562 may be the sides with the longest length.

A protrusion (not shown) may be coupled to the primary positive and return busbars 530, 532 on a side coupled to the coupling, rear, external, and insulator sides 556, 558, 560, 562. However, the protrusion can be located on any portion of the modular busbar assembly 524.

Additionally, the primary positive busbar 530 may have a coupling side 570 intended to be positioned adjacent to the auxiliary positive busbar 526 and may also have three non-coupling sides. The first non-coupling side may be an external side 574 perpendicular to the coupling side 570. The second non-coupling side may be an insulator side 576 opposite the external side 574, and the insulator side 576 may be intended to be positioned adjacent to the insulator 540. The third non-coupling side may be a rear side 572 opposite the coupling side 570. The coupling and rear sides 570, 572 may be the sides with the shortest length, and the external and insulator sides 572, 574 may be the sides with the longest length.

Modular busbar assembly 524 also differs from modular busbar assembly 124 in that the auxiliary positive and return busbars 526, 528 are positioned perpendicular to the longest length of the primary busbars 530, 532. Specifically, the auxiliary return busbar 528 may be coupled to and perpendicular to the coupling side 556 of the primary return busbar 532, and the auxiliary positive busbar 526 may be coupled to and be partially perpendicular to the coupling side 570 of the primary positive busbar 530. The auxiliary return busbar 528 may extend in one direction, which may be a direction perpendicular to the coupling sides 556, 570 of the primary positive and return busbars 530, 532. The auxiliary positive busbar 526 may extend in two directions. A first portion 515 of the auxiliary positive busbar 526 coupled to the coupling side 570 may extend in a direction parallel to the insulator 540 and external side 574 of the primary positive busbar 530, and a second portion 517 of the auxiliary positive busbar 526 interfacing with the connector contacts 588, 590 may extend in the same direction as the auxiliary return busbar 528, which may be perpendicular to the coupling sides 556, 570 of the primary positive and return busbars 530, 532. The angle between the two portions 515, 517 of the auxiliary positive busbar 526 may be 90 degrees. However, the angle between the two portions can be any angle.

In other aspects of the disclosure, the auxiliary positive busbar may extend in one direction, and the auxiliary return busbar may extend in at least two directions. For example, the auxiliary positive busbar may extend in one direction, which may be a direction perpendicular to the coupling side of the primary positive busbar. The auxiliary return busbar may extend in two directions. A first portion of the auxiliary return busbar coupled to the coupling side may extend in a direction parallel with the insulator and external sides of the primary return busbar, and a second portion of the auxiliary return busbar interfacing with the connector contacts may extend in a direction parallel with the auxiliary positive busbar and perpendicular to the coupling sides of the primary positive and return busbars.

In other aspects of the disclosure, the auxiliary positive busbar may be coupled to the external side and extend in the same two directions depicted in FIG. 6A. Alternatively, the auxiliary positive busbar may be coupled to the rear side and may extend in three directions. A first portion of the auxiliary positive busbar coupled to the rear side may extend in a direction parallel with the auxiliary return busbar and perpendicular to the rear side of the primary positive busbar, a second portion may extend in a direction parallel with the insulator and external sides of the primary positive busbar, and a third portion of the auxiliary positive busbar interfacing with the connector contacts may extend in a direction parallel with the auxiliary return busbar.

In other aspects of the disclosure, the auxiliary return busbar may be coupled to the external side and extend in two directions. A portion of the auxiliary return busbar coupled to the coupling side may extend in a direction parallel with the insulator and external sides of the primary return busbar, and a portion of the auxiliary return busbar interfacing with the connector contacts may extend in a direction parallel with the auxiliary return busbar and perpendicular to the coupling sides of the primary return and positive busbars. Alternatively, the auxiliary return busbar may be coupled to the rear side and may extend in three directions. A first portion of the auxiliary return busbar coupled to the rear side may extend in a direction parallel with the auxiliary return busbar and perpendicular to the rear side of the primary return busbar, a second portion may extend in a direction parallel with the insulator and external sides of the primary return busbar, and a third portion of the auxiliary positive busbar interfacing with the connector contacts may extend in a direction parallel with the auxiliary positive busbar.

Modular busbar assembly 524 also differs from modular busbar assembly 124 in that each of the busbars 526, 528, 530, 532 may include one opening receiving a screw, such as screw 536. However, modular busbar assembly 524 can receive any number of openings to receive a screw.

A benefit of modular busbar assembly 524 is that it can function as horizontal busbars and thus save vertical space.

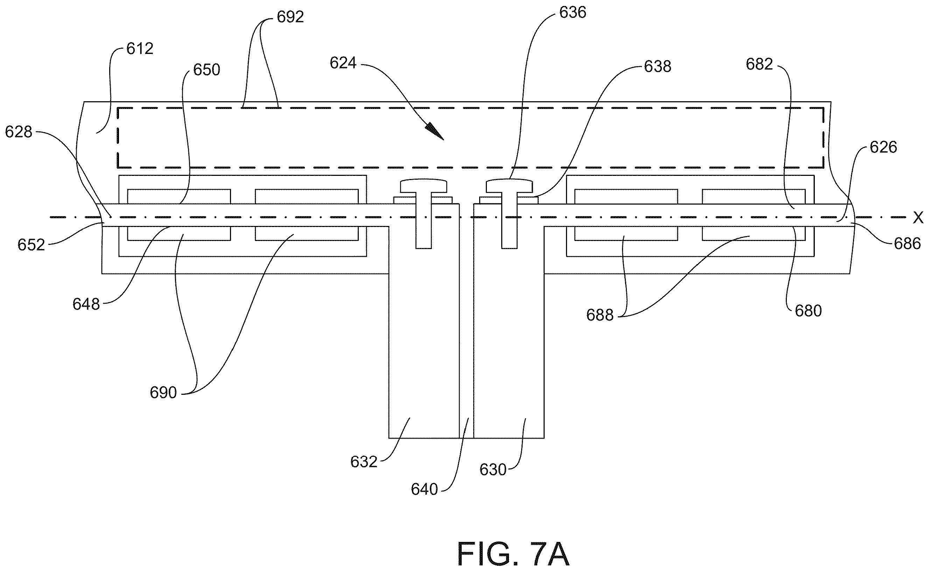

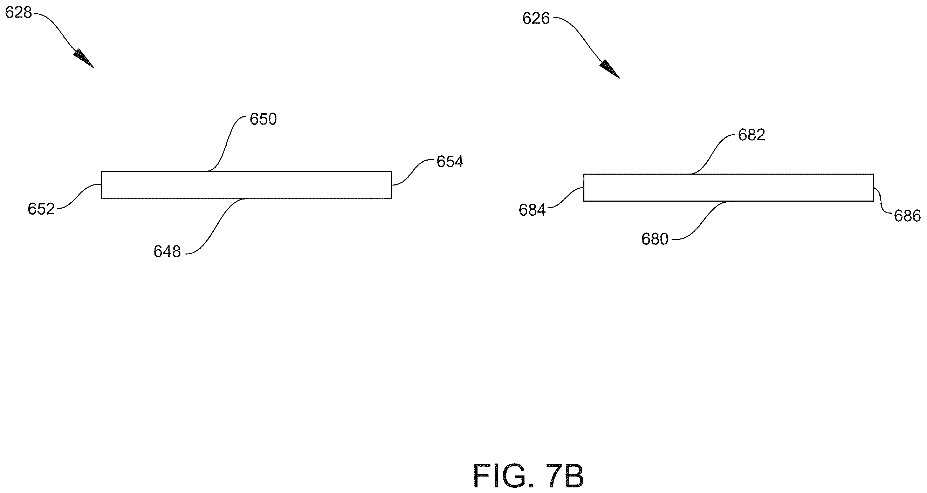

FIGs. 7A-7B illustrate another example of a modular busbar assembly. Modular busbar assembly 624 is similar to modular busbar assembly of 524 of FIGs. 6A-6C, and therefore like elements are referred to with similar numerals within the 600-series of numbers. The description of equivalent features of modular busbar assembly 524 and modular busbar assembly 624 is omitted for brevity.

Modular busbar assembly 624 differs from modular busbar assembly 524 in that the auxiliary return and positive busbars 626, 628 may each extend in only one direction, and the two directions may be opposing. Thus, auxiliary positive busbar 626 may not include a bend. The auxiliary return busbar 628 may extend in a direction away from the primary and auxiliary positive busbars 630, 626, and the auxiliary positive busbar 626 may extend in a direction away from the primary and auxiliary return busbars 632, 628. The auxiliary positive and return busbars 626, 628 may extend along axis X.

This positioning may provide more available space on the powershelf 612 for perforations 692 for cooling so that airflow can exit the powershelf 612. The perforations 692 may be in a rectangular shape, with two edges parallel to and two edges perpendicular to the top and rear sides 556, 558, 570, 572 of the primary positive and return busbars 630, 632. However, the perforations can be any shape, size, or distribution configured for cooling.

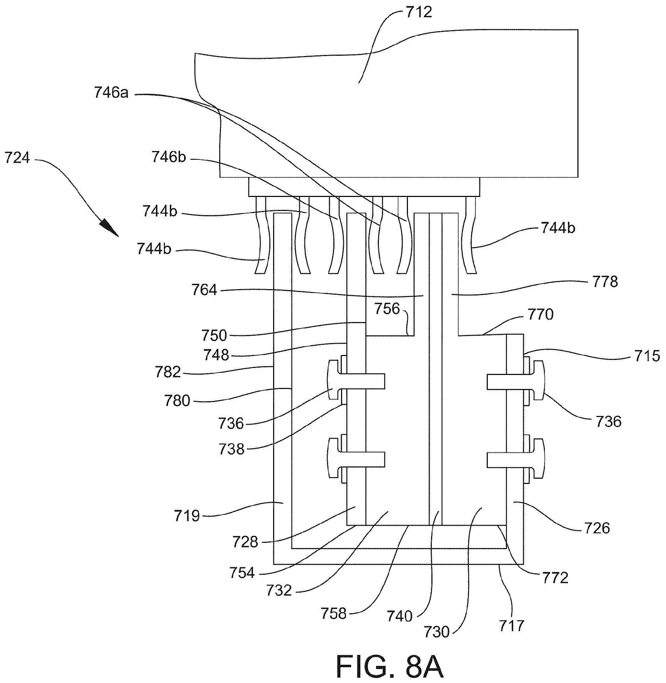

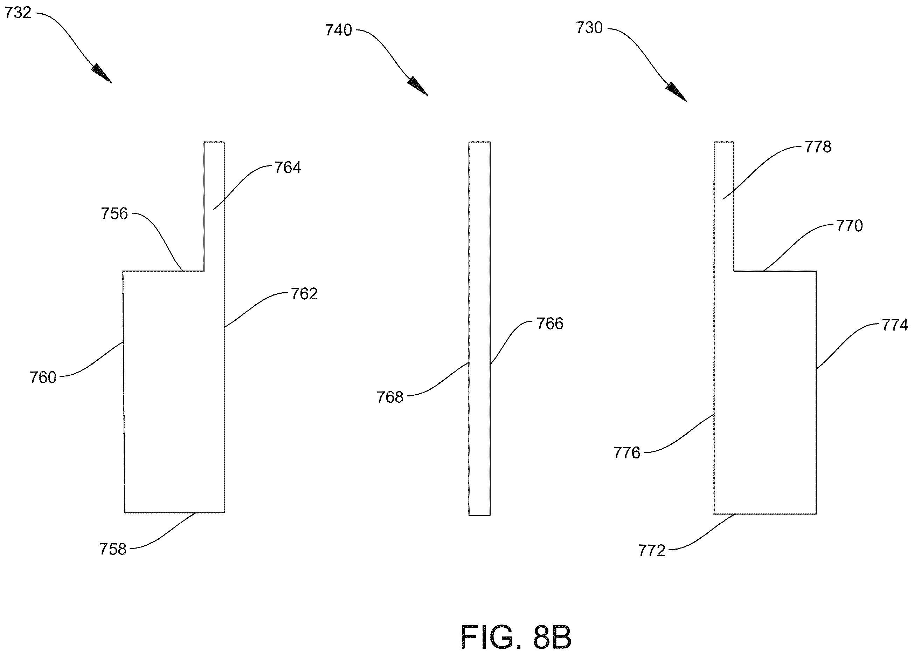

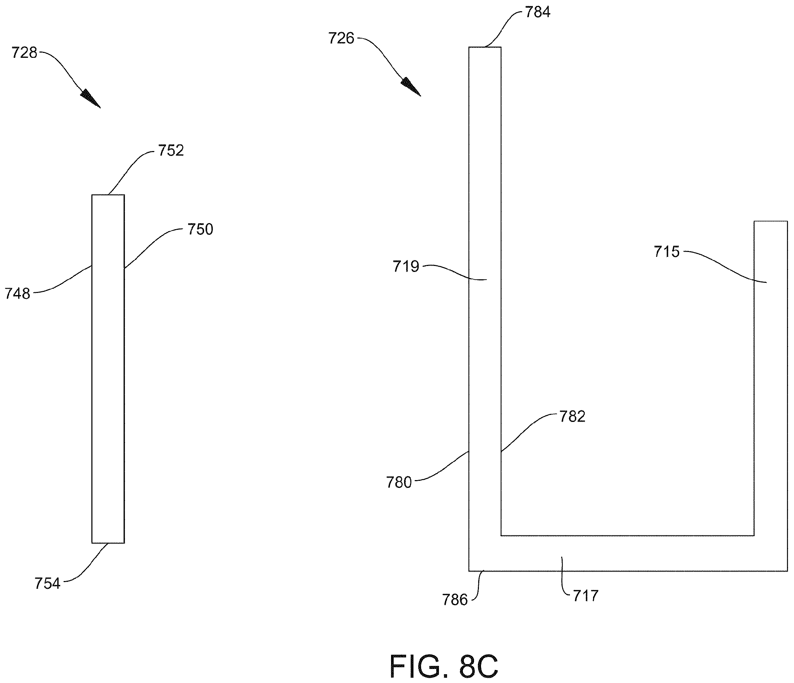

FIGs. 8A-8B illustrates another example modular busbar assembly. Modular busbar assembly 724 is similar to modular busbar assembly 124 of FIGs. 1-2B, and therefore like elements are referred to with similar numerals within the 700-series of numbers. The description of equivalent features of modular busbar assembly 724 and modular busbar assembly 124 is omitted for brevity.

Modular busbar assembly 724 differs from modular busbar assembly 124 of FIGs. 1-2B in that the modular busbar assembly 724 may enable positive contacts to be positioned adjacent to the external side 748 of the auxiliary return busbar 728. Specifically, a first portion 715 of the auxiliary positive busbar 726 coupled to the coupling side 774 of the primary positive busbar 730 may extend in a direction parallel to the coupling side 774 and towards the rear side 772, a second portion 717 may extend in a direction parallel with the rear side 772 of the primary positive busbar 730 and past the auxiliary return busbar 728, and a third portion 719 of the auxiliary positive busbar 726 interfacing with the connectors 744b may extend in a direction parallel with the external side 748 of the auxiliary return busbar 728. The angles between each direction of the auxiliary positive busbar may be 90 degrees. However, the angle between each direction can be any angle.

In other aspects, the auxiliary positive busbar can be coupled to the protrusion side. In such an aspect, the auxiliary positive busbar may extend in a direction parallel to the protrusion side and away from the protrusion and then in a second direction parallel to the protrusion.

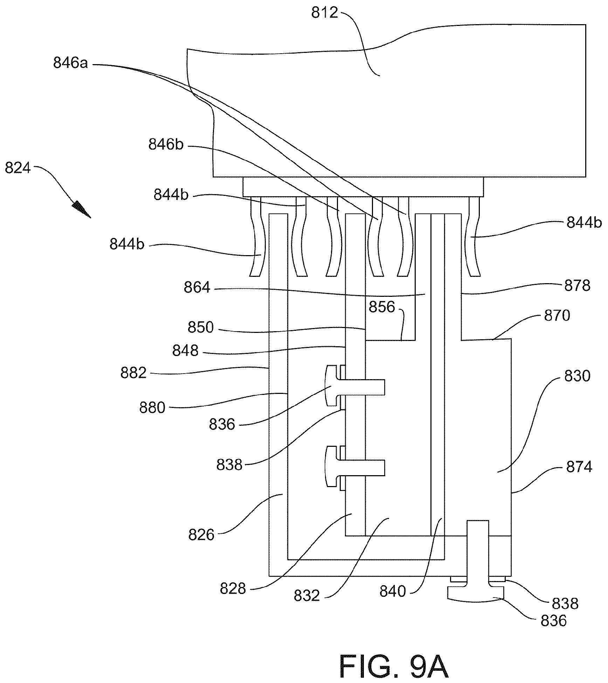

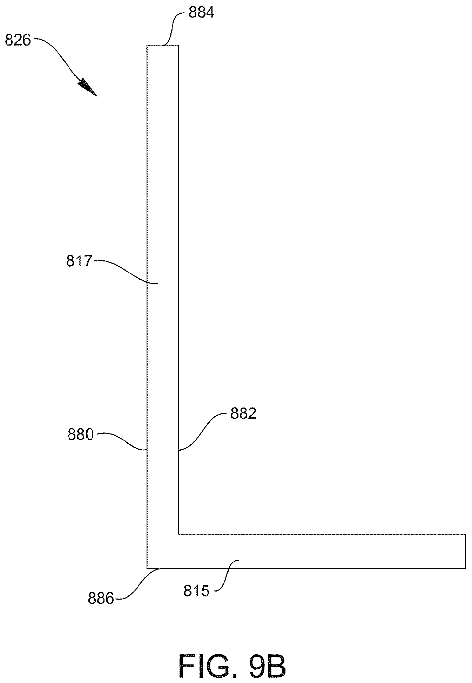

In other aspects, the auxiliary positive busbar can be coupled to the rear side, as discussed in further detail in connection with FIG. 9.

In other aspects, the auxiliary positive busbar can be positioned and shaped as in FIG. 1, and the auxiliary return busbar can be positioned similarly to the auxiliary positive busbar in FIG. 8A. Specifically, a first portion of the auxiliary return busbar coupled to the coupling side of the primary return busbar may extend in a direction parallel to the coupling side and towards the rear side, a second portion may extend in a direction parallel with the rear side of the primary return busbar and past the auxiliary positive busbar, and a third portion of the auxiliary return busbar interfacing with the connector contacts may extend in a direction parallel with the external side of the auxiliary positive busbar.

In other aspects, the auxiliary return busbar can be coupled to the rear side of the primary return busbar. Specifically, a portion of the auxiliary return busbar coupled to the coupling side of the primary return busbar may extend in a direction parallel with the rear side of the primary return busbar and past the auxiliary positive busbar, and a portion of the auxiliary return busbar interfacing with the connector contacts may extend in a direction parallel with the external side of the auxiliary positive busbar. In other aspects, the auxiliary return busbar can be coupled to the protrusion side. In such an aspect, the auxiliary return busbar may extend in a direction parallel to the protrusion side and away from the protrusion and then in a second direction parallel to the protrusion.

In other aspects, the auxiliary busbars may interface with connectors farther down the vertical line on the powershelf. In other words, the positive contacts may be positioned so that a distance between the positive contacts and the auxiliary positive busbar may be smaller than a distance between the positive contacts and the primary positive busbar. Additionally, the return contacts may be positioned so that a distance between the return contacts and the auxiliary return busbar may be smaller than a distance between the return contacts and the primary return busbar. In such aspects, the auxiliary primary and return busbars can be coupled to the coupling, protrusion, or rear side of the primary busbar in which it is coupled to. The side in which the auxiliary positive busbar is coupled may be parallel or transverse to the side in which the auxiliary return busbar is coupled.

FIG. 9 illustrate another example of a modular busbar assembly. Modular busbar assembly 824 is similar to modular busbar assembly 724 of FIG. 8A-8B, and therefore like elements are referred to with similar numerals within the 800-series of numbers. The description of equivalent features of modular busbar assembly 824 and modular busbar assembly 724 is omitted for brevity.

Modular busbar assembly 824 differs from modular busbar assembly 724 of FIG. 8A-8B in that the auxiliary positive busbar 826 may be coupled to the rear side 872 of the primary positive busbar 830. Specifically, a first portion 815 of the auxiliary positive busbar 826 coupled to the rear side 872 of the primary positive busbar 830 may extend in a direction parallel with the rear side 872 of the primary positive busbar 830 and past the auxiliary return busbar 828, and a second portion 817 of the auxiliary positive busbar 826 interfacing with the connectors 844b may extend in a direction parallel with the external side 848 of the auxiliary return busbar 828. The angles between the two directions of the auxiliary positive busbar may be 90 degrees. However, the angle between the two directions can be any angle.

FIG. 10 illustrates another example of a modular busbar assembly. Modular busbar assembly 924 is similar to modular busbar assembly 324 of FIG. 4, and therefore like elements are referred to with similar numerals within the 900-series of numbers. The description of equivalent features of modular busbar assembly 924 and modular busbar assembly 324 is omitted for brevity.

Modular busbar assembly 924 differs from modular busbar assembly 324 of FIG. 4 in that the primary positive and return busbars 930, 932 include recesses. Specifically, a first and second protrusion 964a, 964b are coupled to the protrusion side 956 of the primary return busbar 932, and a third and fourth protrusion 978a, 978b are coupled to the protrusion side 970 of the primary positive busbar 930. The first and second protrusions 964a, 964b may define a first recess 911, and the third and fourth protrusions 978a, 978b may define a second recess 913. The first and second recesses 911, 913 may be sized and shaped to each receive one of double-pole connectors 944, 946. The recesses 911, 913 may be U-shaped. The first, second, third, and fourth protrusions 964a, 964b, 978a, 978b may be the same size and shape as each other. In other aspects, the first, second, third, or fourth protrusions may be differing sizes or shapes, as long as the first and second recesses are a size and shape sufficient to receive a connector.

Modular busbar assembly 924 also differs from modular busbar assembly 324 of FIG. 4 in that a double-pole connector includes a positive double-sided contact 944 and a negative double-sided contact 946 are interfacing with the modular busbar assembly. The positive double-sided contact 944 may be positioned within the first recess 911 and may contact the first and second protrusions 964a, 964b on internal sides within the first recess 911. Similarly, the positive double-sided contact 944a may be positioned within the second recess 913 and may contact the third and fourth protrusions 978a, 978b on internal sides within the second recess 913. In other aspects, the first and/or second recesses may be configured to receive one or two single-pole contacts.

This structure of the first and second recesses 911, 913 may double the side area for current flow by providing two sides on each busbar in which a connector can be interfaced, thus doubling the ampacity compared to existing connectors.

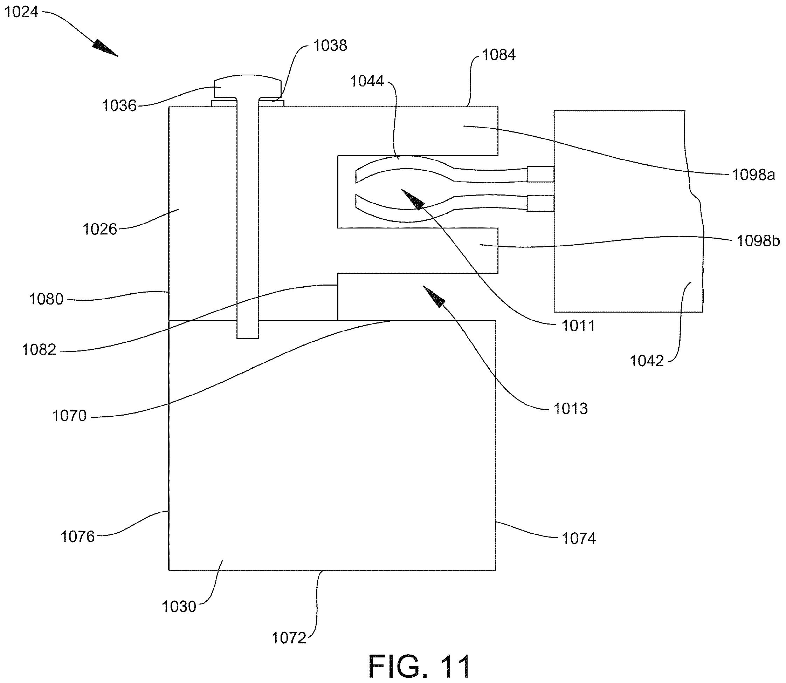

FIG. 11 illustrate another example of a modular busbar assembly. Modular busbar assembly 1024 is similar to modular busbar assembly 324 of FIG. 4, and therefore like elements are referred to with similar numerals within the 1000-series of numbers. The description of equivalent features of modular busbar assembly 1024 and modular busbar assembly 324 is omitted for brevity.

Modular busbar assembly 1024 differs from modular busbar assembly 324 of FIG. 4 in that the auxiliary positive busbar 1026 includes two recesses. Specifically, the protrusion side 1070 of the primary return busbar 1032 does not include a protrusion. Instead, a protrusion (not shown) may be coupled to the primary positive busbar 1030 on a side coupled to the sides 1070, 1072, 1074, and 1076. However, the protrusion can be located on any portion of the modular busbar assembly 1024.

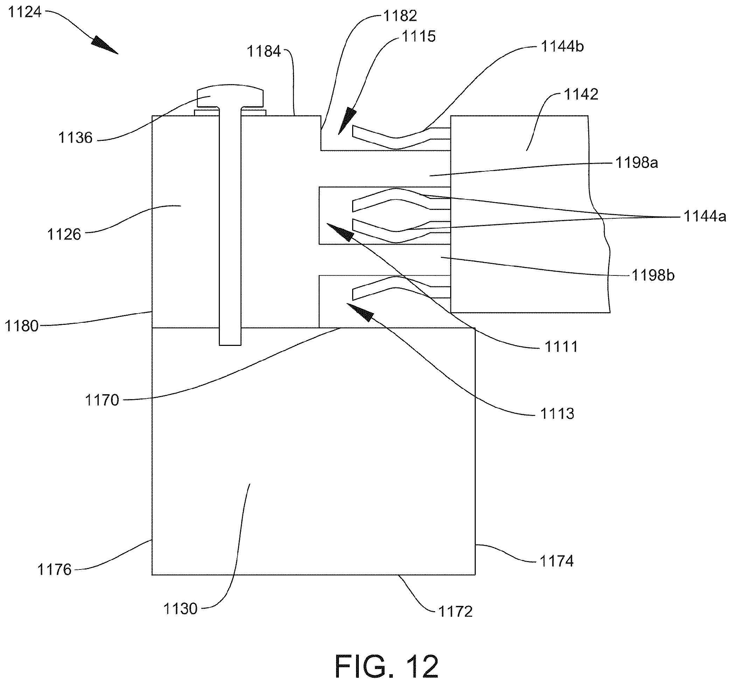

The auxiliary positive busbar 1026 may include a first and second protrusion 1098a, 1098b coupled to a side transverse to the coupling side of primary positive busbar 1030. The first protrusion 1098a may be parallel and in line with a side of the auxiliary positive busbar a opposite of the side coupled to the primary positive busbar 1030. In other aspects, the first protrusion may not be in line with this side, as discussed in further detail in connection with FIG. 12. The first and second protrusions 1098a, 1098b may define a first recess 1011. The coupling side of the primary positive busbar 1030 and the second protrusion 1098b may define a second recess 1013. The first and second recesses 1011, 1013 may be sized and shaped to receive the connector 1044. The recesses 1011, 1013 may be U-shaped. The first and second protrusions 1098a, 1098b may be the same size and shape. In other aspects, the first and second protrusions may be differing sizes or shapes, as long as the recess is a size and shape sufficient to receive a connector with two contacts. The connector may be a single-pole or a double-pole connector, depending on the geometry of the connector housing. If the primary positive and return contacts are combined in the same connector housing, the connector could be a double-pole connector. If the primary positive and return contacts are not in the same connector housing, the connector could be a single-pole connector.

Modular busbar assembly 1024 also differs from modular busbar assembly 324 of FIG. 4 in that only a positive contact 1044 may be interfacing with the modular busbar assembly 1124. The contact 1044 may be positioned within the first recess 1011 and may contact the first and second protrusions 1098a, 1098b on internal sides within the first recess 1011. In other aspects, the first recess 10 11 may receive one or two single-pole connectors. In other aspects, the second recess 1013 may receive one or two single-pole connectors or a double-pole connector, as described in further detail in connection with FIG. 12.

A primary return busbar (not shown) may be positioned adjacent to any of the sides of the primary positive busbar in which the auxiliary positive busbar is not coupled. An auxiliary return busbar may contact any of the sides of the primary return busbar. Additionally, an insulator may be positioned between the primary positive and return busbars.

FIG. 12 illustrates another example of a modular busbar assembly. Modular busbar assembly 1124 is similar to modular busbar assembly of 1040 of FIG. 11, and therefore like elements are referred to with similar numerals within the 1100-series of numbers. The description of equivalent features of modular busbar assembly 1024 and modular busbar assembly 1140 is omitted for brevity.

Modular busbar assembly 1124 differs from modular busbar assembly of 1040 of FIG. 11 in that the first protrusion 1198a may be not in line with side 1184 of the auxiliary positive busbar 1126. Instead, the first protrusion 1198a may be positioned between side 1184 and the second protrusion 1198b so as to define a space 1115 to receive a positive single-pole connector. In other aspects, the space 1115 may receive single-pole connectors with more than two contacts.

Modular busbar assembly 1124 also differs from modular busbar assembly of 1040 of FIG. 11 in that a positive double-pole connector 1144a and two positive single-pole connectors 1144b may interface with the modular busbar assembly. Like in FIG. 11, the positive double-pole connector 1144a may be positioned within the first recess 1111 and may contact the first and second protrusions 1198a, 1198b on internal sides within the first recess 1111. A positive single-pole connector 1144b may be positioned within the second recess 1113 and may contact the second protrusion 1198b on an internal side within the second recess 1113. A positive single-pole connector 1144b may also be positioned within the space 1115 and may contact the first protrusion 1198a on an internal side within the space 1115.

A primary return busbar (not shown) may be positioned adjacent to any of the sides of the primary positive busbar in which the auxiliary positive busbar is not coupled. An auxiliary return busbar may contact any of the sides of the primary return busbar. Additionally, an insulator may be positioned between the primary positive and return busbars.

In other aspects, the modular busbar assemblies may interface with connectors housed in a hybrid connector housing to improve the ampacity of the connectors. Higher RTI materials can be brittle, which may not provide sufficient structure for the connectors. In this hybrid approach, a connector housing may include a primary insulator material with a higher Relative Thermal Index (RTI) enclosing the connectors for electrical and thermal insulation, and a second layer on the primary insulator material include a lower RTI material that can provide structural support to the connector. The primary insulator material, for example, may be silicone rubber or nylon, and the secondary insulator material may be standard plastic housing with 130 RTI, such as glass-reinforced polybutylene terephthalate resins.

In other aspects, the connector housing can include a thermally conductive, electrically insulating composite polymer to spread heat from the connectors and to create more effective side area to be cooled by airflow. This polymer may be used for the entire connector housing or as part of a hybrid connector housing. The polymer may include standard plastics or resins, which may be filled with carbon nanotubes, graphite flakes, boron nitride, or other metallic particles to increase thermal conductivity while remaining electrically non-conductive. The resin may be ABS (a terpolymer synthesized by polymerizing styrene and acrylonitrile in the presence of polybutadiene), polybutylene terephthalate, or nylon. The standard plastics may be polyethylene terephthalate, high-density polyethylene, polyvinyl chloride, low-density polyethylene, polypropylene, or polystyrene.

Although the implementations disclosed herein have been described with reference to particular features, these features are merely illustrative of the principles and applications of the present implementations. Numerous modifications, including changes in the sizes of the various features described herein, may be made to the illustrative implementations and that other arrangements may be devised without departing from the scope of the present implementations. In this regard, the present implementations encompass numerous additional features in addition to those specific features set forth in the paragraphs above.

## Claims

1. A modular busbar assembly comprising:
a primary positive busbar configured to carry a positive current from a source connector, the primary positive busbar comprising a positive body;
a primary return busbar configured to carry a negative current to a return contact, the primary return busbar comprising a return body;
an auxiliary busbar coupled to a coupling side of at least one of the positive body or the return body and spaced apart from the at least one of the primary positive busbar or the primary return busbar to which the auxiliary busbar is coupled; and
a recess defined by a space between the auxiliary busbar and the at least one of the primary positive busbar or the primary return busbar to which the auxiliary busbar is coupled.

2. The modular busbar assembly of claim 1, wherein the recess is U-shaped and configured to receive a connector configured to connect at least one of the source connector or the return contact to the modular busbar assembly.

3. The modular busbar assembly of claim 1 or claim 2, wherein the at least one of the primary positive busbar or the primary return busbar comprises a protrusion side transverse to the coupling side, a protrusion coupled to the protrusion side, and
wherein the auxiliary busbar and the protrusion of the at least one of the primary positive busbar or the primary return busbar define the recess.

4. The modular busbar assembly of any one of claims 1 to 3, wherein the auxiliary busbar and the at least one of the primary positive busbar or the primary return busbar each comprise an opening configured to receive a coupling configured to join the auxiliary busbar to the at least one of the primary positive busbar or the primary return busbar to which the auxiliary busbar is coupled.

5. The modular busbar assembly of any one of claims 1 to 4, wherein the auxiliary busbar is brazed to the at least one of the primary positive busbar or the primary return busbar; and/or
wherein the at least one of the primary positive busbar or the primary return busbar is configured to receive at least one single-pole connector or at least one double-pole connector; and/or
wherein the auxiliary busbar extends in at least one direction parallel to at least one of the coupling side or a noncoupling side of the at least one of the positive body or the return body to which the auxiliary busbar is coupled.

6. The modular busbar assembly of any one of claims 1 to 5, wherein the auxiliary busbar is a positive auxiliary busbar coupled to the primary positive busbar, and further comprising an auxiliary return busbar coupled to the primary return busbar.

7. The modular busbar assembly of claim 6, wherein the recess is a first recess,
wherein the positive body comprises a first protrusion side transverse to the coupling side on the primary positive busbar, a first protrusion coupled to the first protrusion side, the first recess defined by the first protrusion and the auxiliary positive busbar;
wherein the return body comprises a second protrusion side transverse to the coupling side on the primary return busbar, a second protrusion coupled to the second protrusion side, and
further comprising a second recess defined by the second protrusion and the auxiliary return busbar.

8. The modular busbar assembly of claim 7, wherein the coupling side of the primary positive busbar opposes the coupling side of the primary return busbar.

9. The modular busbar assembly of any one of claims 6 to 8, wherein the coupling side of the primary positive busbar is transverse to the coupling side of the primary return busbar; and/or
wherein the auxiliary busbar comprises copper.

10. The modular busbar assembly of any one of claims 1 to 9, wherein the auxiliary busbar comprises an auxiliary busbar recess configured to receive a connector.

11. The modular busbar assembly of claim 10, wherein the connector is a first connector,
wherein the recess is a first recess defined by two protrusions coupled to the auxiliary busbar, and
wherein an external side of one of the two protrusions and the coupling side of the at least one of the positive body or the return body define a second recess configured to receive a second connector.

12. A modular busbar assembly comprising:
a primary positive busbar configured to carry a positive current from a source connector, the primary positive busbar comprising a positive body;
a primary return busbar configured to carry a negative current to a return contact, the primary return busbar comprising a return body; and
an auxiliary busbar coupled to a side of at least one of the positive body or the return body of at least one of the primary positive busbar or the primary return busbar, wherein the auxiliary busbar is positioned transverse to a shortest length of the at least one of the primary positive busbar or the primary return busbar to which the auxiliary busbar is coupled, wherein the shortest length is coupled to a longest length of the at least one of the primary positive busbar or the primary return busbar to which the auxiliary busbar is coupled.

13. The modular busbar assembly of claim 12, wherein the auxiliary busbar is a positive auxiliary busbar coupled to the primary positive busbar, and further comprising an auxiliary return busbar coupled to the primary return busbar.

14. The modular busbar assembly of claim 13, wherein a first coupling side of the primary positive busbar and a second coupling side of the primary return busbar extend along an axis; and/or
wherein the auxiliary positive busbar and the auxiliary return busbar are positioned along an axis so that the auxiliary positive busbar is configured to interface with a series of positive contacts along the axis and so that the auxiliary return busbar is configured to interface with a series of return contacts along the axis, or
wherein the auxiliary positive busbar and a portion of the auxiliary return busbar are parallel so that the auxiliary positive busbar is configured to interface with a series of positive connector contacts parallel to a series of return contacts, the auxiliary return busbar configured to interface with the series of return contacts.

15. A modular busbar assembly comprising:
a primary positive busbar configured to carry a positive current from a source connector, the primary positive busbar comprising a positive body having an opening configured to receive a coupling, the positive body comprising a coupling side and a protrusion side transverse to the coupling side, a protrusion coupled to the protrusion side;
a primary return busbar configured to carry a negative current to a return contact, the primary return busbar comprising a return body having an opening configured to receive a coupling, the return body comprising a coupling side and a protrusion side transverse to the coupling side, a protrusion coupled to the protrusion side; and
an auxiliary busbar coupled to a side of at least one of the positive body or the return body of at least one of the primary positive busbar or the primary return busbar via a coupling in the opening of the at least one of the positive body or the return body to which the auxiliary busbar is coupled, the auxiliary busbar spaced apart from the at least one of the primary positive busbar or the primary return busbar to which the auxiliary busbar is coupled.
